# EUROPEAN PATENT SPECIFICATION

(11) **EP 0 465 064 B1**
(45) Date of publication and mention of the grant of the patent: **09.12.1998**
(21) Application number: 91305644.6
(22) Date of filing: 21.06.1991
(51) Int. Cl.: G03F 7/039, G03F 7/36

(54) **Process for forming patterns**
Verfahren zur Erzeugung eines Musters
Procédé de formation d'image

(30) Priority: 29.06.1990 JP 172005/90; 29.06.1990 JP 172006/90
(43) Date of publication of application: 08.01.1992
(73) Proprietor: FUJITSU LIMITED, Kawasaki-shi, Kanagawa 211 (JP)
(72) Inventor: Abe, Naomichi, Setagaya-ku, Tokyo 158 (JP); Nozaki, Koji, Kawasaki-shi, Kanagawa 211 (JP)
(74) Representative: Perry, Robert Edward

(56) References cited:
- EP-A- 102 450
- DE-A- 2 726 813
- US-A- 4 241 165
- REICHMANIS E. ET AL 'Polymers in microlithography. Materials and process' 1989 , AMERICAN CHEMICAL SOCIETY , WASHINGTON DC

## Description

### BACKGROUND OF THE INVENTION

### 1. Field of the Invention

The present invention relates to a process for the formation of resist patterns having a good sensitivity and a high remaining thickness rate, by which submicron patterns can be obtained.

### 2. Description of the Related Art

The integration of semi-conductive integrated circuits has become greater, to enable the use of LSIs and VLSIs, and is realized by the miniaturization of conductor lines and electrodes. Currently, those having a minimum pattern width of approximately 1 µm are in practical use.

In a recent resist pattern-forming process, after the exposure, the development is carried out using an organic solvent such as methyl isobutyl ketone (abbreviated as MIBK), and the pattern formation is carried out by utilizing the difference of solubilities of exposed and unexposed regions in the organic solvent. In the case of a development using a solvent, however, it is difficult to form submicron patterns, since a swelling due to the solvent cannot be avoided.

For this reason, a dry development process has been proposed as a means of solving the above problem. Japanese Unexamined Patent Publication (Kokai) No. 63-15244 discloses that the dry development is carried out in a downflow stream of oxygen-containing plasma by using a resist comprising a specific polymer as a main agent and an acid chloride as an auxiliary.

Such dry development, however, have the problems of an insufficient sensitivity or a low remaining thickness rate, and thus, no such process has yet been put to practical use. In particular, this problem is severe in excimer laser exposure which is expected to be an exposure means in future or X-ray exposure, since the light intensities are small.

### SUMMARY OF THE INVENTION

An object of the present invention is, therefore, to provide a resist capable of obtaining submicron patterns even by the dry development process and to provide a process for the formation of resist patterns using same.

According to the present invention, there is provided a process for patterning, which comprises applying a resist material comprising a mixture of at least one polymer selected from the polymers represented by the following formulae I and II, 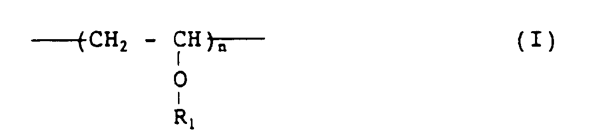 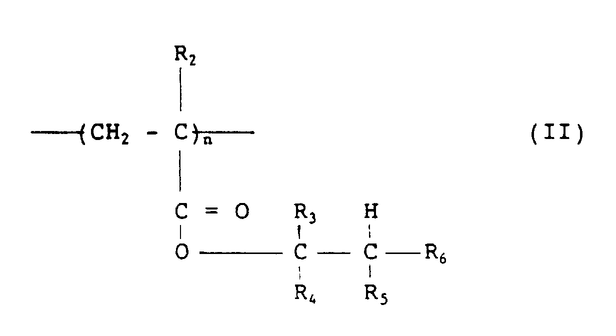 wherein R₁ represents an aryl or an aralkyl group, R₂ represents hydrogen or an alkyl group, R₃ , R₃, R₅ and R₆ independently represent hydrogen, a halogen atom, an alkyl, an aryl or an aralkyl group, with the proviso that at least one of R₃, R₄, R₅ and R₆ represents an aryl or aralkyl group, with a substance which generates an acid by exposure on a substrate to be treated, followed by exposure to ultra-violet rays, X-rays or an electron beam and heat treatment, and then developing the system in a downflow stream of oxygen-containing plasma.

### DESCRIPTION OF THE INVENTION

The process of the invention may be conducted in dry development apparatus of the type illustrated in the accompanying drawing. The drawing shows an inlet 1 for gas into a chamber 2 in which there is a microwave shielding plate 3. The plasma accumulates above the plate 3, and passes downstream towards the substrate 4 under the influence of a vacuum applied at the outlet 5. The process is under the control of a magnetron 6.

As to the materials that are used in the present invention, the vinyl ether polymers represented by formula I and the acrylate polymers represented by formula II are used alone or as a mixture of two or more polymers. The repeating units of these polymers contain an aromatic structure.

Examples of photo acid generators suitable for use in the present invention include triphenylsulfonium hexafluoroarsenate, diphenyliodonium hexafluorophosphate, 2,5-dinitrobenzyl-p-toluenesulfonate, N-(p-toluene-sulfonyloxy)phthalimide, phenacyl-p-borophenylsulfone, triphenylsulfonium tetraborate, p-(m-nitrophenylsulfonyl)-toluene, 1,3,5-tris(2,3-dibromopropyl)-1,3,5-triazine-2,4,6(1H,3H,5H)-trione, 2,4-bis(trichloromethyl)-6-phenyl-1,3,5-triazine or 2,4,6-tribromophenol.

When a resist of the present invention is applied onto a substrate to be treated, exposed, and then heated, a reaction (shown below) takes place; the catalyst is a Brönsted acid (H⁺) which is generated from the photo acid generator by exposure. For example, where polyvinyl benzyl ether is used as the polymer of formula I, the following reaction takes place, and the polyvinylbenzyl ether on the exposed region is decomposed into polyacetylene and benzyl alcohol. 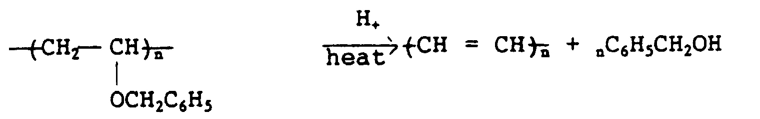 Where poly-α,α'-dimethylbenzyl methacrylate is used the following reaction takes place, and the poly-α,α'-dimethyl benzyl methacrylate on the exposed region is decomposed into polymethacrylic acid and α-methyl styrene, the α-methyl styrene being removed by heating.

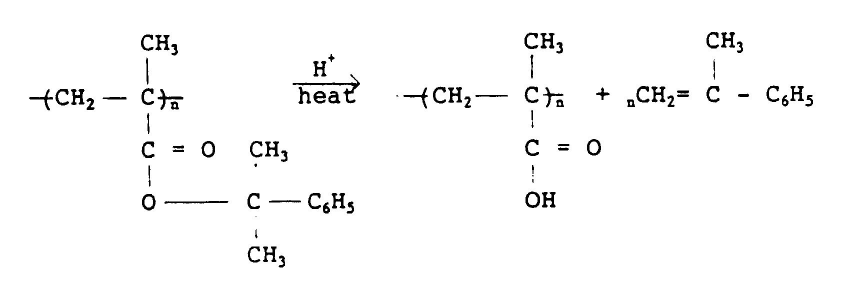

As disclosed in Japanese Unexamined Patent Publication (Kokai) No. 63-15244, in the downflow development where a mixed gas of oxygen (O₂) and tetrafluorocarbon (CF₄) or a mixed gas of oxygen (O₂) and nitrogen (N₂) is introduced into a plasma by a microwave irradiation from a magnetron oscillator, etc., and then an etching is carried out using neutral radicals existing in the downflow, the etching proceeds only by pure chemical reactions, and consequently, this process provides a very effective pattern formation.

To be specific, when the substrate to be treated is in a plasma formed by the microwave irradiating, ions and electrons exist due to the dissociation of the gaseous molecules, aside from radicals, and the substrate is also subjected to a physical etching by the impact of the ions and electrons. In contrast, since only radicals exist in the downflow, the etching is carried out only by the chemical reactions, when the substrate is apart from the plasma.

For the exposure of the resist material of the present invention, ultra-violet ray, X-ray and electron beam can be employed. Further, it is desirable that the temperature of the heat treatment effected after the exposure is in a range of from 50 to 200°C.

The polymer obtained by exposing the resist and then heating it, and which contains double bonds in the main chain, e.g., the above-mentioned polyacetylene or polymethacrylic acid, is etched at an especially high speed in the downflow development, and the by-product, benzyl alcohol or α-methylstyrene has a low boiling point, which is removed by heating. On the other hand, since the polymer in the unexposed region contains a large amount of aromatic rings, it is etched at a low speed, and as a result, positive type resist patterns are obtained.

According to the present invention, a resist having a good sensitivity, because of chemical amplification out, which is free of swelling because it is dry developed with an excellent rate of a remaining thickness, can be obtained, and makes it possible to form submicron patterns in the formation of a semiconductor integrated circuit.

The present invention will now be described in detail with reference to the following examples, but is not intended to be restricted thereto.

### Synthetic Example 1

1-Chloroethyl-benzyl ether was obtained by reacting acetaldehyde with benzyl alcohol in ethylene glycol dimethyl ether (abbreviated as GLYME), and was then reacted with potassium t-butoxide in t-butyl alcohol at a temperature of 80°C to obtain vinylbenzyl ether, which was then reacted with the aid of azobisisobutyronitrile (abbreviated as AIBN) catalyst at 40°C to obtain poly-vinylbenzyl ether. As the source for exposure usable for the exposure, a KrF lamp and excimer laser can also be mentioned.

### Synthetic Example 2

Commercially available α,α'-dimethylbenzyl alcohol and methacryloyl chloride were reacted in dry tetrahydrofuran (abbreviated as THF) using n-butyl lithium for 30 minutes, and then refluxed over a period of 2 hours.

The resulting substance was then polymerized using azobisisobutyronitrile (abbreviated as AIBN) as a catalyst, to obtain poly-α,α'-dimethylbenzyl methacrylate.

### Synthetic Example 3

Poly-phenylethyl methacrylate was synthesized in the same manner as in Synthetic Example 2.

### Example 1

The poly-vinylbenzyl ether obtained in Synthetic Example 1 and an amount of triphenylsulfonium hexafluoro-arsenate [(C₆,H₅)₃SAs₅F₆] corresponding to 5% by weight of the former were mixed, and the mixture was spun-coated on an Si-substrate using a solvent, and after drying, was exposed by an Xe-Hg lamp over a period of about 5 minutes, and then heated at 120°C for 5 minutes.

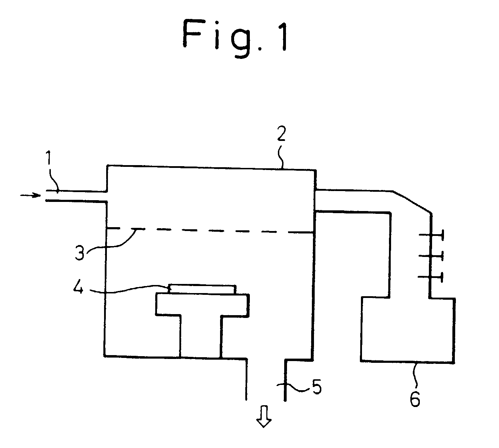

Thereafter, the Si-substrate was set on a downstream position of a dry development apparatus as shown in Fig. 1. The atmosphere was evacuated while feeding O₂ at a flow rate of 1000 SCCM and CF₄ at 200 SCCM so that the interior of the apparatus was maintained at 6 torr. Under such a condition, a plasma was formed with a microwave power of 750 W, to carry out a downflow development.

As a result, the rate of remaining thickness was 85%, the sensitivity was 50 mJ/cm², and a resolution of 0.8 µm was attained.

### Example 2

Commercially available polyvinyl phenyl ether and an amount of diphenyliodium hexafluorophosphate [(C₆,H₅)₂IPF₆ corresponding to 5% by weight of the former were mixed, and the mixture was spun-coated on an Si-substrate using a solvent, and after drying, it was exposed by means of an Xe-Hg lamp over a period of about 5 minutes, and then heated at 120°C for 5 minutes.

Thereafter, the Si-substrate was set on a downstream position of a dry development apparatus as shown in Fig. 1. The downflow development was carried out under the same conditions as in Example 1.

As a result, the rate of the remaining thickness was 88%, the sensitivity was 30 mJ/cm², and a resolution of 1.0 µm was attained.

### Example 3

A resist film was formed on an Si-substrate in exactly the same manner as in Example 2. The Si-substrate was then set on a downstream region of a dry development apparatus as shown in Fig. 1. The atmosphere was evacuated while feeding O₂ at a flow rate of 1000 SCCM and N₂ at 200 SCCM so that the interior of the apparatus was maintained at 5 torr. Under such a condition, a plasma was formed with a microwave power of 750 W to carry out a downflow development at a substrate temperature of 100°C.

As a result, the rate of the remaining thickness was 80%, the sensitivity was 30 mJ/cm², and a resolution of 1.2 µm was attained.

### Example 4

A resist was prepared from a commercially available polyvinylphenyl ether and an amount of 2,5-dinitrobenzyl-p-toluene-sulfonate corresponding to 5% by weight of the former. The resist was spin-coated on an Si-substrate using a solvent, and dried, and then exposed by an Xe-Hg-lamp over a period of about 5 minutes, and heated at 120°C for 5 minutes.

Thereafter, the Si-substrate was set on a downstream region of a dry development apparatus as shown in Fig. 1. The atmosphere was evacuated while feeding O₂ at a flow rate of 1000 SCCM and N₂ at 200 SCCM so that the interior of the apparatus was maintained at 5 torr. Under such a condition, a plasma was formed with a microwave power of 750 W to carry out a downflow development at a substrate temperature of 100°C.

As a result, the rate of the remaining thickness was 85%, the sensitivity was 40 mJ/cm², and a resolution of 0.8 µm was attained.

### Example 5

A resist was prepared from a mixture of poly-α,α'-dimethylbenzyl methacrylate obtained in Synthetic Example 2 and an amount of N-[(p-toluenesulfonyl)oxy]phthalimide corresponding to 5% by weight of the former compound. The resist was spun-coated on an Si-substrate using a solvent, and dried, and then exposed by an Xe-Hg-lamp over a period of about 5 minutes, and then heated at 120°C for 5 minutes.

Thereafter, the Si-substrate was set on a downstream region of a dry development apparatus as shown in Fig. 1. The atmosphere was evacuated while feeding O₂ at a flow rate of 1000 SCCM and CF₄ at 200 SCCM so that the interior of the apparatus was maintained at 6 torr. Under such a condition, a plasma was formed with a microwave power of 750 W to carry out a downflow development.

As a result, the rate of the remaining thickness was 90%, the sensitivity was 30 mJ/cm², and a resolution of 0.8 µm was attained.

### Example 6

A resist was prepared from a mixture of poly-phenylethyl methacrylate obtained in Synthetic Example 3 and an amount of phenacyl-p-borophenylsulfone corresponding to 5% by weight of the former compound. The resist was spun-coated on an Si-substrate using a solvent, and dried, and then exposed by an Xe-Hg-lamp over a period of about 5 minutes, and heated at 120°C for 5 minutes.

Thereafter, the Si-substrate was set on a downstream position of a dry development apparatus as shown in Fig. 1, and the downflow development was carried out under the same conditions as in Example 5.

As a result, the rate of the remaining thickness was 90%, the sensitivity was 40 mJ/cm², and a resolution power of 0.7 µm was attained.

### Example 7

A resist film was formed on an Si-substrate in exactly the same manner as in Example 6. The Si-substrate was then set on a downstream region of a microwave plasma etching apparatus as shown in Fig. 1. The atmosphere was evacuated while feeding O₂ at a flow rate of 1000 SCCM and N₂ at 200 SCCM so that the interior of the apparatus was maintained at 5 torr. Under such a condition, a plasma was formed with a microwave power of 750 W to carry out a downflow development at a substrate temperature of 100°C.

As a result, the rate of the remaining thickness was 85%, the sensitivity was 30 mJ/cm², and a resolution of 0.9 µm was attained.

### Example 8

A mixture of poly-phenylethyl methacrylate obtained in Synthetic Example 3 and an amount of triphenylsulfonium tetraborate corresponding to 5% by weight of the former compound was spin-coated on an Si-substrate using a solvent, and dried, and then exposed by an Xe-Hg-lamp over a period of about 5 minutes, and heated at 120°C for 5 minutes.

Thereafter, the Si-substrate was set on a downstream position of a dry development apparatus as shown in Fig. 1, and the downflow development was carried out under the same conditions as in Example 6.

As a result, the rate of the remaining thickness was 90%, the sensitivity was 50 mJ/cm², and a resolution of 0.8 µm was attained.

Although, in the above examples, the resist material of the present invention was used as a single layer, it can be used as an upper layer resist of a multi-layer resist structure. Namely, the resist material of the present invention is applied onto a laminated planing resist and mask film structure. After patterning the resist material of the present invention, by selectively etching the mask film using the resist pattern as a mask, and then patterning the lower layer planing resist by using the mask film pattern as a mask, a highly precise resist pattern can be obtained even on a rough surface.

## Claims

1. A patterning process, which comprises applying onto a substrate a resist material comprising a polymer of formula I or II 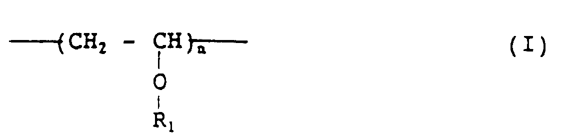 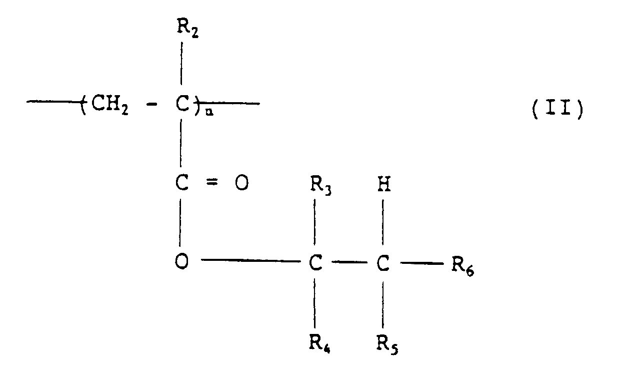 wherein R₁ is aryl or aralkyl, R₂ is H or alkyl, and R₃, R₄, R₅ and R₆ are independently H, halogen, alkyl, aryl or aralkyl, provided that at least one of R₃, R₄, R₅ and R₆ is aryl or aralkyl; and a substance which generates an acid by exposure;
subjecting the material to exposure using ultra-violet rays, X-rays or an electron beam, followed by heat treatment; and
developing the resulting system in a downflow stream of oxygen-containing plasma.

2. A process according to claim 1, wherein the polymer is polyvinylbenzyl ether, polyvinylphenyl ether, poly-α,α-dimethylbenzyl methacrylate or polyphenylethyl methacrylate.

3. A process according to claim 1 or claim 2, wherein the acid-generating substance is triphenylsulfonium hexafluoroarsenate, diphenyliodonium hexafluorophosphate, 2,5-dinitrobenzyl-p-toluenesulfonate, N-(p-toluenesulfonyloxy)phthalimide, phenacyl-p-borophenylsulfone, triphenylsulfonium tetraborate, p-(m-nitrophenylsulfonyl)toluene, 1,3,5-tris(2,3-dibromopropyl)-1,3,5-triazine-2,4,6(1H,3H,5H)-trione, 2,4-bis(trichloromethyl)-6-phenyl-1,3,5-triazine or 2,4,6-tribromophenol.

4. A process according to any preceding claim, wherein the heat treatment is carried out at 50 to 200°C.

5. A process according to any preceding claim, wherein the resist material is applied directly onto the surface of the substrate or as an upper layer resist of a multi-layer resist structure onto a laminated planing resist and mask film structure.

## Patentansprüche

1. Musterungsprozeß, der umfaßt:
Auftragen, auf ein Substrat, eines Resistmaterials aus einem Polymer mit der Formal I oder II 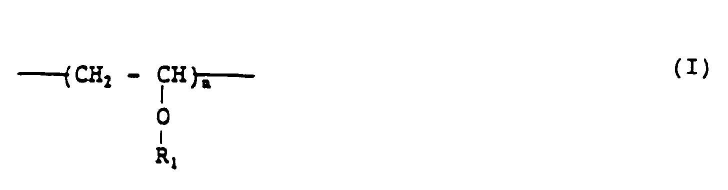 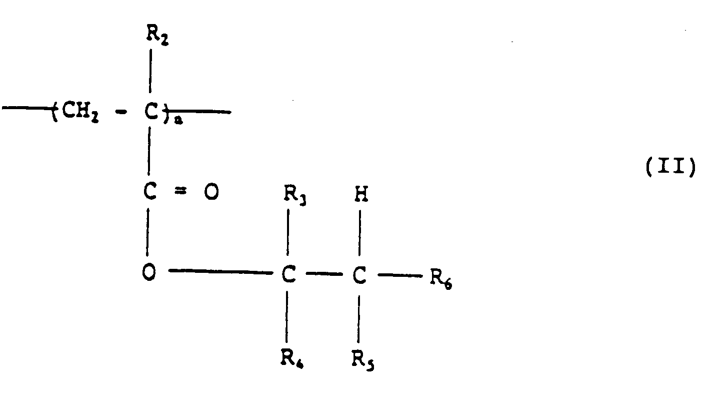 wobei R₁ Aryl oder Aralkyl ist, R₂ H oder Alkyl ist und R₃, R₄, R₅ und R₆ unabhängig H, Halogen, Alkyl, Aryl oder Aralkyl sind, unter der Bedingung, daß wenigstens eines von R₃, R₄, R₅ und R₆ Aryl oder Aralkyl ist; und einer Substanz, die durch Belichtung eine Säure erzeugt;
Aussetzen des Materials einer Belichtung unter Verwendung von ultravioletten Strahlen, Röntgenstrahlen oder einem Elektronenstrahl, woran sich eine Wärmebehandlung anschließt; und
Entwickeln des resultierenden Systems in einem Abwärtsflußstrom von sauerstoffhaltigem Plasma.

2. Prozeß nach Anspruch 1, bei dem das Polymer Polyvinylbenzylether, Polyvinylphenylether, Poly-α,α-Dimethylbenzylmethacrylat oder Polyphenylethylmethacrylat ist.

3. Prozeß nach Anspruch 1 oder Anspruch 2, bei dem die säureerzeugende Substanz Triphenylsulfoniumhexafluoroarsenat, Diphenyliodiumhexafluorophosphat, 2,5-Dinitrobenzyl-p-toluensulfonat, N-(p-Toluensulfonyloxy)phthalimid, Phenacyl-p-borophenylsulfon, Triphenylsulfoniumtetraborat, p-(m-Nitrophenylsulfonyl)-toluen, 1,3,5-tris(2,3-Dibrompropyl)-1,3,5-triazin-2,4,6(1H,3H,5H)-trion, 2,4-bis(Trichlormethyl)-6-phenyl-1,3,5-triazin oder 2,4,6-Tribromphenol ist.

4. Prozeß nach irgendeinem vorhergehenden Anspruch, bei dem die Wärmebehandlung bei 50 bis 200 °C erfolgt.

5. Prozeß nach irgendeinem vorhergehenden Anspruch, bei dem das Resistmaterial direkt auf die Oberfläche des Substrats oder als Resist der oberen Schicht einer mehrschichtigen Resiststruktur auf ein Planierungsresist und eine Maskenfilmstruktur, die laminiert sind, aufgetragen wird.

## Revendications

1. Traitement de formation de motif, qui comprend l'application sur un substrat d'un matériau de résist comprenant un polymère de formule I ou II 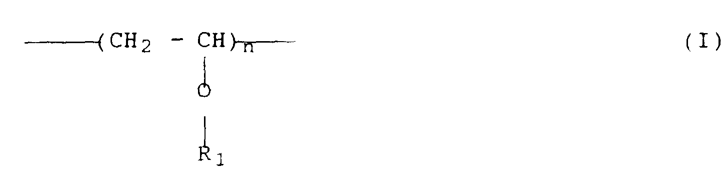 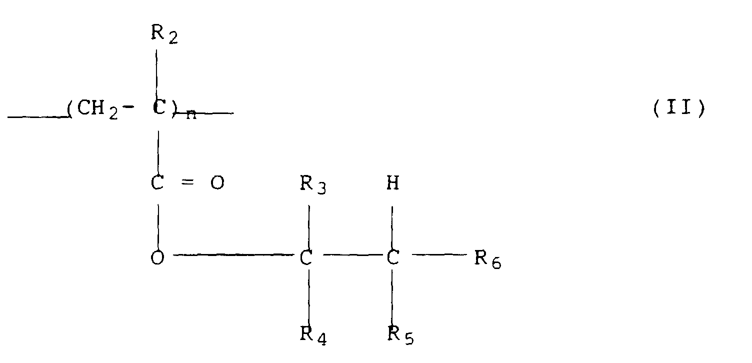 où R₁ est un aryle ou un aralkyle, R₂ est un H ou alkyle, et R₃, R₄, R₅ et R₆ sont de façon indépendante H, halogène, alkyle, aryle ou aralkyle, pourvu qu'au moins un de R₃, R₄, R₅ et R₆ soit un aryle ou aralkyle ; et une substance qui génère un acide par exposition ;
soumission des matériaux à l'exposition en utilisant des rayons ultraviolets, des rayons X, ou un faisceau électronique, suivi par un traitement thermique ; et
développement du système résultant dans le flux de courant descendant de plasma contenant de l'oxygène.

2. Traitement selon la revendication 1, dans lequel le polymère est de l'éther de polyvinylbenzyle, de l'éther de polyvinylphényle, du méthacrylate polydiméthylbenzyle -α, α', ou du méthacrylate polyphényléthyle.

3. Traitement selon la revendication 1, ou la revendication 2, dans lequel le substrat de génération d'acide est de l'hexafluoroarsenate de triphénylsulfonium, de l'hexafluorophosphate de diphényliodonium, du toluènesulfonate p -dinitrobenzyle --2,5, phthalimide (sulfonyloxy-toluène p)-N, du borophénylsulfone-p-phénacyle, du tétraborate triphénylsulfonium, du toluène-(nitrophénylsulfonyle-m)-p, de trione (1H, 3H, 5H)-2, 4, 6 - triazine-1, 3, 5 -(tris(dibromopropyle-2, 3)-1, 3, 5, de la triazine 1, 3, 5-phényl-6bis(trichlorométhyle)-2, 4 ou du tribromophénol-2, 4, 6.

4. Traitement selon l'une quelconque des revendications précédentes, dans lequel le traitement thermique est réalisé de 50 à 200°C.

5. Traitement selon l'une quelconque des revendications précédentes, où le matériau de résist est appliqué directement sur la surface du substrat ou comme un résist de couche supérieure d'une structure de résist multicouche sur un résist de nivelage laminé et de structure de film de masque.
